# FASCICULE DE BREVET EUROPEEN

(11) **EP 1 792 526 B1**
(45) Date de publication et mention de la délivrance du brevet: **15.07.2009**
(21) Numéro de dépôt: 05782605.9
(22) Date de dépôt: 07.09.2005
(51) Int. Cl.: H05K 1/02, H05K 3/34, H05K 3/44, H05K 7/20, H01L 23/498, H01L 23/34

(54) **DISPOSITIF ELECTRONIQUE AVEC REPARTITEUR DE CHALEUR INTEGRE**
MIT INTEGRIERTEM WÄRMEVERTEILER AUSGESTATTETE ELEKTRONISCHE EINRICHTUNG
ELECTRONIC DEVICE PROVIDED WITH AN INTEGRATED HEAT SPREADER

(30) Priorité: 21.09.2004 FR 0409974
(43) Date de publication de la demande: 06.06.2007
(73) Titulaire: 3D Plus, 78532 Buc Cedex (FR)
(72) Inventeur: VAL, Christian, F-78470 ST REMY LES CHEVREUSE (FR); LIGNIER, Olivier, F-78000 VERSAILLES (FR); BOCAGE, Régis, F-92370 CHAVILLE (FR)
(74) Mandataire: Henriot, Marie-Pierre
(86) Numéro de dépôt international: PCT/EP2005/054419
(87) Numéro de publication internationale: WO 2006/032611

(56) Documents cités:
- US-A- 6 058 012
- US-A1- 2002 190 362
- US-A1- 2003 080 392
- US-B1- 6 313 399

## Description

La présente invention concerne un dispositif électronique intégrant un répartiteur de chaleur. Il s'applique plus particulièrement aux dispositifs de type boîtiers plastiques, à un ou plusieurs niveaux de composants.

Pour répondre à un besoin toujours plus grand de réduire les dimensions des composants électroniques, il est connu de l'art antérieur des dispositifs électroniques sous forme de boîtiers à l'intérieur desquels sont disposés les composants, par exemple en céramique ou en plastique, cette dernière catégorie étant la plus répandue. Le boîtier comprend un support en matériau isolant sur lequel sont agencés les composants, sur un ou plusieurs niveaux, les composants étant recouverts d'un enrobage, par exemple en matériau plastique de type epoxy. Le support présente sur chacune de ses faces interne et externe des plots de connexion, respectivement pour la connexion des composants et pour la connexion du boîtier sur un substrat.

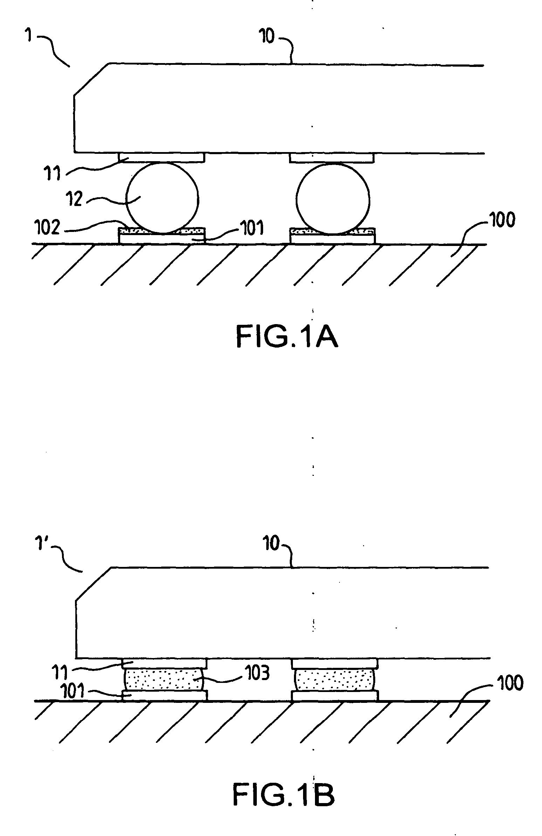

Les figures 1A et 1B montrent respectivement des exemples de boîtiers 1 de type BGA (abréviation de l'expression anglo-saxonne « Ball Grid Array ») et 1' de type LGA (abréviation de l'expression anglo-saxonne « Land Grid Array »), destinés à être connectés sur un substrat 100. Seule l'enveloppe 10 du boîtier est représentée. A l'intérieur sont agencés le support et les composants électroniques sur un ou plusieurs niveaux (non représentés). Les boîtiers sont équipés de plots de connexion externe 11 pour la connexion à des plots de connexion 101 du substrat 100. Dans l'exemple de la figure 1A, le plus répandu, les plots de connexion externe 11 du boîtier sont munis de billes 12, d'où la dénomination 'BGA', permettant une plus grande facilité de positionnement des plots de connexion en vis-à-vis. Les billes sont brasées aux plots 101 du substrat par apport d'une couche de brasures 102, par exemple en alliage étain/plomb ou en alliage sans plomb. Mais une brasure sans billes, directement de plot à plot, est également possible. C'est l'exemple des boîtiers de type LGA tels que représentés sur la figure 1B. Dans ce cas, l'apport d'une couche de brasure 103 permet de braser directement le plot de connexion externe 11 du boîtier au plot de connexion 101 du substrat.

La fabrication de boîtiers tels que décrits sur les figures 1A ou 1B par exemple, nécessite une étape de chauffage pour souder par brasure l'ensemble des plots de connexion du boîtier aux plots de connexion du substrat, qu'ils soient ou non équipés de billes. Lors de cette étape, le boîtier est passé dans un four à haute température. La température peut atteindre environ 230°C, voire même davantage dans le cas d'apport de brasure sans plomb. Du fait de la dimension de ce type de boîtier (de 5 à 50 mm typiquement), le nombre de plots de connexion est considérable (plusieurs centaines, voire quelques milliers) et lors du passage dans le four, la température qui est atteinte au niveau des plots situés dans une position centrale du boîtier est très inférieure (40°C à 80°C) à celle atteinte au niveau des plots situés à la périphérie, en particulier dans les boîtiers plastiques du fait de la faible conduction thermique des matériaux utilisés. Cette inhomogénéité de la température au niveau des différents plots de connexion conduit à augmenter encore la température de chauffe du four pour s'assurer que la température atteinte au centre sera suffisante pour le brasage, au risque de détériorer les composants électroniques situés dans le boîtier, ainsi que tous ceux à l'extérieur du boîtier.

La présente invention permet de remédier aux inconvénients précités grâce à un dispositif électronique, muni pour sa connexion externe de plots répartis sur une surface de connexion, caractérisé en ce qu'il comprend une plaque conductrice de la chaleur, disposée parallèlement à la dite surface de connexion, et présentant une structure non uniforme permettant, lorsque le dispositif est soumis à une température extérieure donnée, un apport de chaleur contrôlée au niveau de chaque plot de connexion externe, en fonction de sa position sur la surface de connexion.

La plaque conductrice de la chaleur ainsi intégrée dans le dispositif permet une répartition de la chaleur apportée de l'extérieur sur toute la surface de connexion, permettant de limiter ainsi la température de chauffe du four lors du brasage des plots de connexion externes.

Selon une variante, le dispositif électronique est de type boîtier comprenant un support de type circuit imprimé, la plaque conductrice formant une couche interne du support.

Selon une autre variante, la plaque conductrice est multicouche, formant une interconnexion thermique permettant de contrôler l'apport de chaleur au niveau de chaque plot de connexion externe du dispositif.

Le dispositif selon l'invention peut présenter des composants électroniques agencés sur un ou plusieurs niveaux selon différentes variantes de mise en oeuvre.

D'autres avantages et caractéristiques apparaîtront plus clairement à la lecture de la description qui suit, illustrée par les figures annexées qui représentent :
- Les figures 1A et 1B, des exemples de boîtiers de type BGA et LGA (déjà décrites) ;
- La figure 2, un premier exemple de réalisation d'un dispositif électronique selon l'invention (vue partielle), avec plaque conductrice de la chaleur;
- La figure 3, un second exemple de réalisation d'un dispositif électronique selon l'invention (vue partielle), avec plaque conductrice de la chaleur;
- Les figures 4A et 4B, un troisième exemple de réalisation d'un dispositif électronique selon l'invention (vue partielle), avec plaque conductrice de la chaleur, selon deux vues;
- Les figures 5A et 5B, des vues en coupe d'un dispositif électronique de type boîtier, selon l'invention, avec respectivement un ou plusieurs niveaux de composants électroniques, selon une variante ;
- La figure 6, une vue en coupe d'un dispositif électronique de type boîtier, selon l'invention, avec plusieurs niveaux de composants électroniques, selon une seconde variante;
- La figure 7, un exemple de réalisation d'une plaque conductrice de la chaleur selon un quatrième exemple de réalisation, agencée dans un dispositif électronique du type de celui de la figure 6 ;
- Les figures 8A à 8D, des vues du dispositif de la figure 7.

Sur les figures, les éléments identiques sont repérés par les mêmes références.

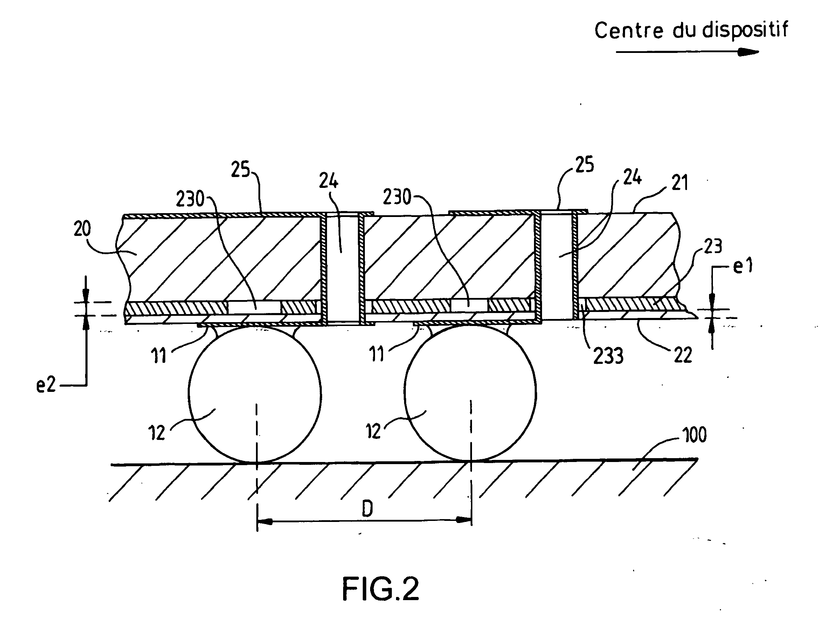

Les figures 2, 3 et 4A, 4Breprésentent trois exemples de réalisation d'un dispositif électronique selon l'invention. Ces dispositifs sont de type boîtiers BGA, mais l'invention s'appliquerait tout aussi bien à d'autres types de boîtiers . Seules quelques billes de connexion 12 sont représentées par souci de clarté mais dans un dispositif réel, il peut y avoir typiquement quelques centaines de billes. Le boîtier comprend un support 20 formé d'au moins une couche de matériau isolant électrique avec une face supérieure 21 et une face inférieure 22, la face inférieure 22 formant la surface de connexion externe du dispositif Le dispositif électronique est muni pour sa connexion externe de plots 11 répartis sur la surface de connexion 22. Selon l'invention, le dispositif comprend une plaque conductrice de la chaleur 23, disposée parallèlement à la dite surface de connexion 22, et présentant une structure non uniforme permettant, lorsque le dispositif est soumis à une température extérieure donnée, un apport de chaleur contrôlée au niveau de chaque plot de connexion externe 11, en fonction de sa position sur la surface de connexion.

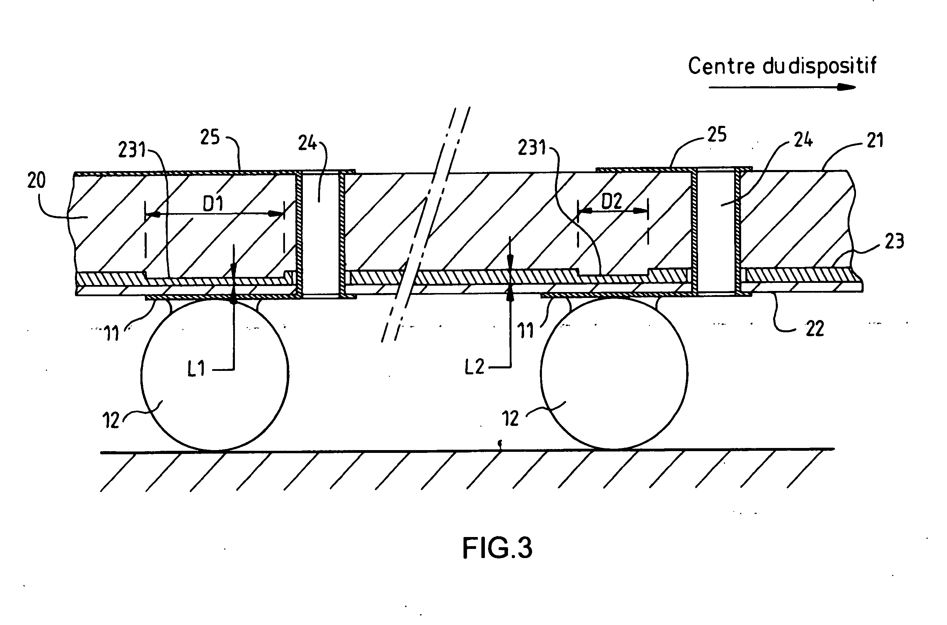

Selon l'exemple des figures 2 et 3, la plaque conductrice 23 est située au-dessus de ladite surface de connexion 22, c'est-à-dire du côté opposé à la face portant les plots de connexion externe 11.

Dans l'exemple de la figure 2, la plaque conductrice est formée d'une couche de matériau conducteur de la chaleur, par exemple en cuivre ou en carbone, percée d'ouvertures 230 de géométrie variable, situées par exemple au-dessus des plots de connexion 11. Grâce à la géométrie particulière de ces ouvertures, la résistance thermique de la plaque entre l'extérieur du dispositif et la zone située au-dessus du plot peut être contrôlée, permettant d'obtenir vers le centre du dispositif, un apport de chaleur comparable à celui apporté en périphérie. Pour ce faire, les ouvertures sont par exemple formées de trous sensiblement cylindriques, positionnés au-dessus des plots 11 de la surface de connexion, dont les diamètres Dᵢ sont calculés en fonction de la position du plot sur la surface de connexion pour rendre l'apport de chaleur sensiblement homogène sur toute la surface. Ainsi dans l'exemple de la figure 2, le diamètre D₂ est supérieur au diamètre D₁, les diamètres des ouvertures 230 étant d'autant plus importants que l'on s'éloigne du centre du dispositif. La couche en matériau conducteur de la chaleur 23 est également percée dans cet exemple de trous 233 pour le passage de connecteurs électriques 24 reliant les plots de connexion externe 11 à des plots de connexion interne 25, disposés sur la surface supérieure du support 20, et permettant la connexion aux composants électroniques (non représentés). Dans cet exemple, la couche en matériau conducteur de chaleur 23, est située parallèlement à la surface de connexion 22, le plus près possible de celle-ci afin de favoriser la diffusion de la chaleur de la plaque vers les plots. Typiquement, les billes de connexion sont disposées à une distance D inférieure au millimètre les unes des autres. On cherchera à disposer la plaque conductrice 23 à proximité de la surface de connexion, par exemple l'épaisseur e1 séparant la plaque de ladite surface sera d quelques dizaines de microns, typiquement 50 µm, et l'épaisseur de la plaque comprise entre 30 et 150 µm.

Dans l'exemple de la figure 3, la plaque conductrice 23 est également formée d'une couche de matériau conducteur de la chaleur. A la différence de la figure 2 cependant, les ouvertures dans la plaque conductrice sont remplacées par des zones d'épaisseur variable, dont les épaisseurs L₁, L₂ sont également calculées pour rendre l'apport de chaleur sensiblement homogène sur toute la surface. Par exemple, les zones 231 sont sensiblement cylindriques, positionnées au-dessus des plots de la surface de connexion, et présentent des diamètres variables, notés D₁, D₂ sur la figure 3, fonction de la position des plots au-dessus desquels elles sont situées.

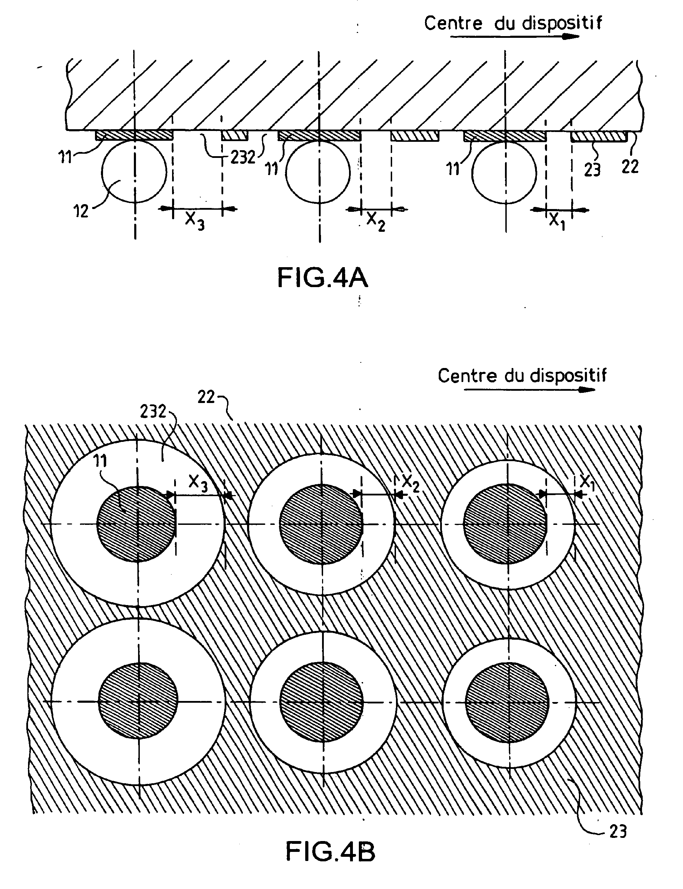

Dans l'exemple des figures 4A et 4B, la plaque conductrice 23 est située en-dessous de la surface de connexion 22, c'est-à-dire du même côté vis-à-vis de la surface de connexion que les plots de connexion externe 11. Cette variante présente l'avantage de limiter les pertes de chaleur dans le support. En pratique, la plaque conductrice 23 peut être formée d'une couche de matériau conducteur de la chaleur présentant également des propriétés de conduction électrique, les plots de connexion externe 11 étant formés dans la couche 23 elle-même. La figure 4A représente une vue en coupe, tandis que la figure 4B représente une vue de dessous (les billes 12 n'étant pas apparentes). Par exemple, la plaque conductrice 23 est formée d'une couche en matériau conducteur de chaleur et conducteur électrique, par exemple du cuivre, la plaque étant découpée selon un schéma faisant apparaître les plots de connexion externe 11, autour desquels sont laissés des anneaux 232 sans matériau conducteur de chaleur, de diamètres variables X₃, X₂, X₁, respectivement de plus en plus fin au fur et à mesure que l'on s'approche du centre du dispositif, toujours dans le but e contrôler la résistance thermique de la plaque de l'extérieur du dispositif à chacun des plots de connexion 11, afin de tenter d'avoir une homogénéité la plus grande au niveau de chaque plot.

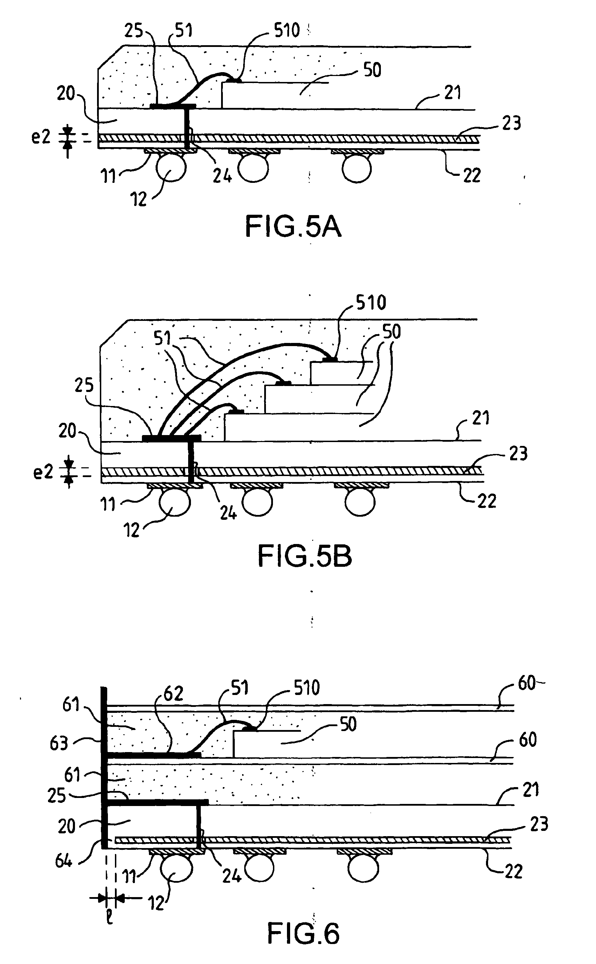

Les figures 5A, 5B et 6 montrent trois exemples de dispositifs électroniques selon l'invention, tous de type BGA, équipés d'une plaque conductrice de chaleur 23 formée d'une couche en matériau conducteur de chaleur disposée parallèlement à la surface de connexion 22, et présentant une structure non uniforme permettant, lorsque le dispositif est soumis à une température extérieure donnée, un apport de chaleur contrôlée au niveau de chaque plot de connexion externe 11. Dans ces exemples, la couche en matériau conducteur est agencée au-dessus de la surface de connexion, et présente la forme par exemple des plaques décrites au moyen des figures 2 et 3, seuls les trous de passage des connecteurs 24 étant représentés. Par exemple, le support 20 étant de type circuit imprimé multicouche, la couche en matériau conducteur thermique 23 forme une des couches du circuit imprimé. Selon une variante, la couche 23 pourrait tout aussi bien être disposée au-dessous de la surface de connexion, comme dans l'exemple de la figure 4A.

La figure 5A représente un boîtier électronique de type boîtier plastique à un niveau de composants. Les composants notés 50 sont connectés électriquement au support 20 du boîtier par un fil de connexion 51 reliant un plot de connexion interne 25 sur le support à un plot de connexion 510 du composant électronique. Les composants sont enrobés d'une couche de matériau plastique de type époxy. La figure 5B représente un boîtier électronique de type boîtier plastique à plusieurs niveaux de composants. La structure est similaire à celle du boîtier représenté sur la figure 5A, à la différence que des composants sont empilés les uns sur les autres, tous reliés à des plots de connexion interne 25 du support 20 par des fils de connexion 51.

La figure 6 représente un boîtier électronique de type boîtier plastique à plusieurs niveaux de composants. Dans cet exemple, les composants sont empilés dans une structure à trois dimensions de type décrite dans le brevet français FR 2 670 323 au nom de la déposante. Dans cette structure, les composants électroniques 50 sont agencés selon des motifs donnés sur des substrats 60, reliés par des fils de connexion 51 à des plots de connexion 62 disposés sur les substrats. Les substrats sont enrobés d'une couche isolante 61 de type époxy, et empilés les uns sur les autres, sur le support 20. Une particularité de cette structure est notamment la connexion électrique des composants par les faces latérales du boîtier, au moyen de connexions notées 63 qui relient les plots de connexion 62 aux plots de connexion internes 25 du support 20, et non plus par des fils de connexion interne, reliant directement les plots de connexion des composants aux plots de connexion internes 25. Dans ce cas, la couche de matériau conducteur de la chaleur 23 est préférentiellement de dimensions inférieures à celle du support 20 de telle sorte à ne pas risquer de court-circuit si le matériau conducteur de chaleur utilisé est aussi conducteur électrique. De cette façon, une bande d'isolation 61 d'épaisseur ℓ présente autour de la plaque conductrice permet d'assurer l'isolation électrique. La plaque présente alors avantageusement un nombre donné de pattes de prise de connexion thermique sur sa périphérie (non représentées sur la figure 6).

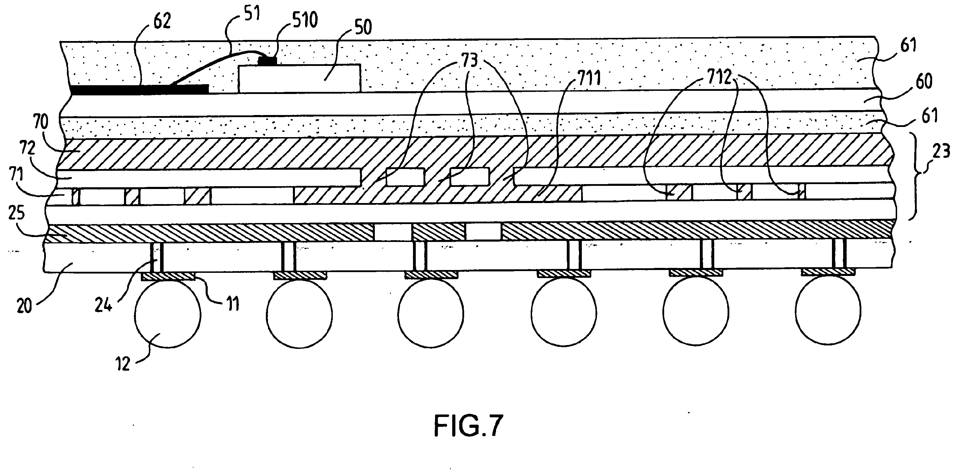

La figure 7 représente un exemple de réalisation d'une plaque conductrice de la chaleur selon un quatrième exemple de réalisation, particulièrement intéressant dans un dispositif électronique du type de celui de la figure 6.

Selon cette variante, la plaque conductrice 23 est formée d'une alternance de couches en matériau conducteur et isolant de la chaleur, de telle sorte à former une interconnexion thermique permettant de contrôler l'apport de chaleur au niveau de chaque plot. Plus précisément dans cet exemple, la plaque 23 comprend une première couche supérieure 70 en matériau conducteur de chaleur, uniforme, et une seconde couche inférieure 71 en matériau conducteur de chaleur, reliée thermiquement à ladite première couche par des connexions thermiques 73. Les deux couches 70 et 71 sont séparées par une couche en matériau isolant thermique 72. La couche inférieure 71 présente une géométrie non uniforme, formant un ensemble de conducteurs thermiques (711, 712) de résistance thermique variable, agencés selon un motif donné pour le contrôle de l'apport de chaleur au niveau de chaque plot de connexion externe 11.

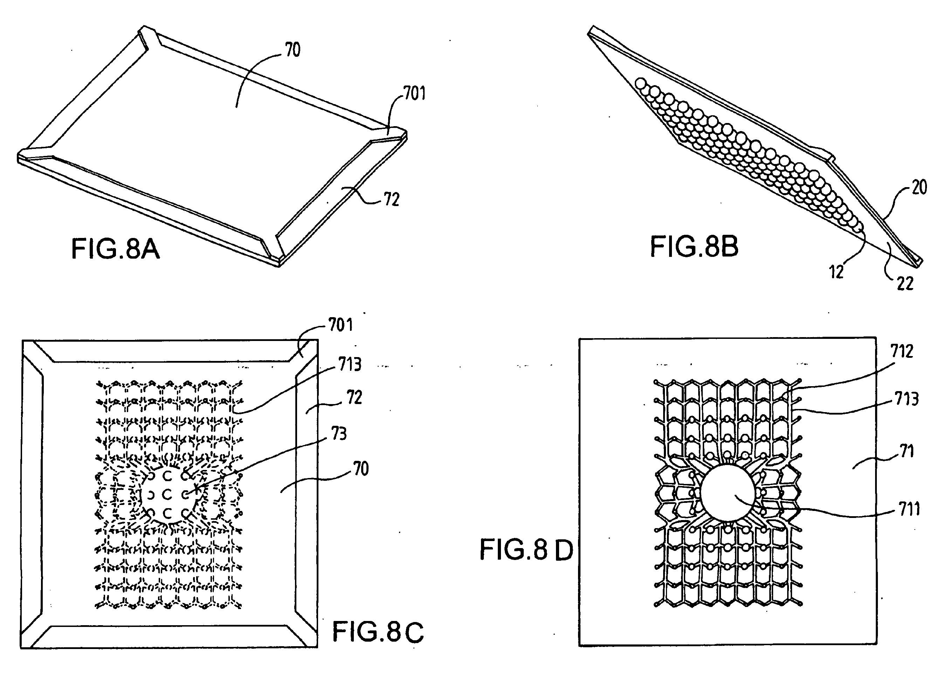

Cet exemple est illustré au moyen des différentes vues (partielles) du dispositif illustrées sur les figures 8A à 8D. La figure 8A montre une vue de dessus de la première couche supérieure 70 en matériau conducteur de chaleur, disposée sur la couche en matériau isolant 72. La couche 70 est sensiblement uniforme et, comme dans l'exemple de la figure 6, elle est de dimensions inférieures à celles de la couche de matériau isolant pour ne pas provoquer de court-circuit avec les connexions électriques latérales (non représentées), lorsqu'elle est réalisée en matériau présentant également des propriétés de conducteur électrique. Comme précédemment, des pattes 701 de prise de connexion thermique sont alors prévues sur sa périphérie, une à chaque coin, ou tout autour de la couche, pour améliorer la conduction de la chaleur extérieure. La figure 8B montre une vue de dessous du dispositif électronique sur laquelle sont apparentes les billes de connexion 12 fixées sur les plots de la surface de connexion externe 22, face inférieure du support 20. Les figures 8C et 8D montrent un exemple de géométrie de la couche inférieure 71. Il s'agit d'une vue de dessus de la couche supérieure 70 (figure 8C) et d'une vue de dessus de la couche 71 (figure 8D). Les éléments des couches inférieures sont indiquées en pointillé sur la figure 8C. Notamment, sont représentés en pointillé les connexions thermiques 73 qui relient, à travers la couche isolante thermiquement 72, la couche conductrice de chaleur 70 à la couche conductrice de chaleur 71. Dans cet exemple, la géométrie de la couche conductrice de chaleur 71 est constituée d'un disque central (711) connecté à la couche 70 par les connexions thermiques 73, de plots 712 de tailles variables en fonction de la position sur la couche et de lignes conductrices de chaleur 713, formant ainsi les conducteurs thermiques de résistance thermique variable, qui permettent d'apporter au-dessus de chaque plot de connexion externe 11 du dispositif électronique, une quantité de chaleur sensiblement identique, quelle que soit leur position sur la surface de connexion.

## Revendications

1. Dispositif électronique (1, 1') muni pour sa connexion externe de plots (11) répartis sur une surface de connexion (22), **caractérisé en ce qu'**il comprend une plaque (23) conductrice de la chaleur, disposée parallèlement à la dite surface de connexion, et présentant une structure non uniforme formée d'une couche de matériau conducteur de la chaleur, présentant des zones (231) d'épaisseur variable positionnées au-dessus desdits plots de la surface de connexion, permettant, lorsque le dispositif est soumis à une température extérieure donnée, un apport de chaleur contrôlée au niveau de chaque plot de connexion externe, en fonction de sa position sur la surface de connexion.

2. Dispositif électronique selon la revendication 1, **caractérisé en ce que** ladite plaque conductrice est située au-dessus de ladite surface de connexion.

3. Dispositif électronique selon la revendication 2, **caractérisé en ce que** l'épaisseur des zones étant nulle, ces zones forment des ouvertures (230) et **en ce que** ces ouvertures ont une géométrie variable.

4. Dispositif électronique selon l'une des revendications 1 à 3, **caractérisé en ce que** les zones sont sensiblement cylindriques de diamètre variable en fonction de la position.

5. Dispositif électronique selon la revendication 2, **caractérisé en ce que** ladite plaque conductrice (23) est formée d'une alternance de couches (70, 71, 72) en matériau conducteur et isolant de la chaleur, de telle sorte à former une interconnexion thermique permettant de contrôler l'apport de chaleur au niveau de chaque plot.

6. Dispositif électronique selon la revendication 5, **caractérisé en ce que** ladite plaque comprend une première couche supérieure (70) en matériau conducteur de chaleur, uniforme, et une seconde couche inférieure (71) en matériau conducteur de chaleur, reliée thermiquement à ladite première couche, formant un ensemble de conducteurs thermiques (713) de résistance thermique variable, agencés selon un motif donné pour le contrôle de l'apport de chaleur au niveau de chaque plot.

7. Dispositif selon l'une des revendications 1 à 6, **caractérisé en ce que** ledit matériau conducteur de la chaleur est du cuivre.

8. Dispositif selon l'une des revendications 1 à 6, **caractérisé en ce que** ledit matériau conducteur de la chaleur est du carbone.

9. Dispositif électronique selon la revendication 1, **caractérisé en ce que** ladite plaque conductrice est située en-dessous de ladite surface de connexion, et présente également des propriétés de conduction électrique, les plots de connexion externe étant formés dans ladite couche.

10. Dispositif électronique selon l'une des revendications précédentes, **caractérisé en ce que** le dispositif est de type boîtier, comportant un support (20) formé d'au moins une couche de matériau isolant électrique avec une face supérieure (21) et une face inférieure (22), la face inférieure formant ladite surface de connexion externe du dispositif, et comportant en outre un ensemble de composants électroniques (50) agencés selon un ou plusieurs niveaux, les composants étant connectés par des conducteurs électriques (51) à des plots de connexion interne (25) disposés sur la face supérieure dudit support, les plots de connexion interne étant reliés aux dits plots de la surface de connexion externe.

11. Dispositif électronique selon la revendication 10, **caractérisé en ce que** ledit support étant multicouche et ladite plaque conductrice située au-dessus de ladite surface de connexion, ladite plaque conductrice (23) forme une ou plusieurs desdites couches du support, ladite plaque étant percée pour le passage desdits connecteurs électriques.

12. Dispositif électronique selon la revendication 10, **caractérisé en ce que** lesdits composants électroniques sont agencés sur ledit support sur plusieurs niveaux, les composants des niveaux supérieurs étant connectés aux plots de connexion interne par des connexions (63) situées sur des faces latérales extérieures du boîtier.

13. Dispositif électronique selon la revendication 12, **caractérisé en ce que** ladite plaque conductrice de la chaleur (23) présentant au moins une couche en matériau conducteur, ladite couche est de dimensions inférieures à celle du support et présente un nombre donné de pattes (701) de prise de connexion thermique sur sa périphérie.

14. Dispositif électronique selon l'une des revendications précédentes, **caractérisé en ce que** lesdits plots de connexion externe sont munis de billes (12).

## Claims

1. Electronic device (1, 1') provided for its external connection with pads (11) distributed over a connection surface (22), **characterized in that** it includes a heat-conducting plate (23) placed parallel to said connection surface and having a nonuniform structure formed from a layer of heat-conducting material having zones (231) of variable thickness that are positioned above said pads on the connection surface, making it possible, when the device is exposed to a given external temperature, to supply a controlled amount of heat to each external connection pad according to its position on the connection surface.

2. Electronic device according to Claim 1, **characterized in that** said conducting plate is above said connection surface.

3. Electronic device according to Claim 2, **characterized in that**, when the thickness of the zones is zero, the zones form apertures (230) and **in that** these apertures are of variable geometry.

4. Electronic device according to one of Claims 1 to 3, **characterized in that** the zones are approximately cylindrical with a diameter that varies with the position.

5. Electronic device according to Claim 2,
**characterized in that** said conducting plate (23) is formed by an alternation of layers (70, 71, 72) made of thermally conducting material and thermally insulating material, in such a way as to form a thermal interconnection for controlling the supply of heat to each pad.

6. Electronic device according to Claim 5, **characterized in that** said plate comprises a uniform upper first layer (70) of thermally conducting material and a lower second layer (71) of thermally conducting material that is thermally coupled to said first layer, forming an assembly of thermal conductors (713) of variable thermal resistance that are arranged in a given pattern in order to control the supply of heat to each pad.

7. Device according to one of Claims 1 to 6,
**characterized in that** said thermally conducting material is copper.

8. Device according to one of Claims 1 to 6,
**characterized in that** said thermally conducting material is carbon.

9. Electronic device according to Claim 1, **characterized in that** said conducting plate lies below said connection surface and also has electrical conduction properties, the external connection pads being formed in said layer.

10. Electronic device according to one of the preceding claims, **characterized in that** the device is of the package type, comprising a support (20) formed by at least one layer of electrically insulating material with an upper face (21) and a lower face (22), the lower face forming said external connection surface of the device, and furthermore including a set of electronic components (50) placed on one or more levels, the components being connected by electrical conductors (51) to internal connection pads (25) on the upper face of said support, the internal connection pads being connected to said pads on the external connection surface.

11. Electronic device according to Claim 10,
**characterized in that**, when said support is a multilayer support and said conducting plate lies above said connection surface, said conducting plate (23) forms one or more of said layers of the support, said plate being pierced for passage of said electrical connectors.

12. Electronic device according to Claim 10, **characterized in that** said electronic components are arranged on said support on various levels, the components of the upper levels being connected to the internal connection pads via connections (63) located on external lateral faces of the package.

13. Electronic device according to Claim 12, **characterized in that**, when said thermally conducting plate (23) has at least one layer of conducting material, said layer has smaller dimensions than that of the support and has a given number of thermal connection leads (701) on its periphery.

14. Electronic device according to one of the preceding claims, **characterized in that** said external connection pads are provided with balls (12).

## Patentansprüche

1. Elektronische Vorrichtung (1, 1'), die für ihren externen Anschluss mit Kontaktplättchen (11) versehen ist, die auf einer Anschlussfläche (22) verteilt sind, **dadurch gekennzeichnet, dass** sie eine wärmeleitende Platte (23) enthält, die parallel zur Anschlussfläche angeordnet ist und eine ungleichmäßige Struktur hat, die von einer Schicht aus wärmeleitendem Werkstoff gebildet wird, welche Zonen (231) variabler Dicke hat, die über den Kontaktplättchen der Anschlussfläche positioniert sind, was, wenn die Vorrichtung einer gegebenen Außentemperatur ausgesetzt ist, eine gesteuerte Wärmezufuhr in Höhe jedes externen Anschlusskontaktplättchens in Abhängigkeit von seiner Position auf der Anschlussfläche erlaubt.

2. Elektronische Vorrichtung nach Anspruch 1, **dadurch gekennzeichnet, dass** die leitende Platte sich über der Anschlussfläche befindet.

3. Elektronische Vorrichtung nach Anspruch 2, **dadurch gekennzeichnet, dass**, wenn die Dicke der Zonen Null ist, diese Zonen Öffnungen (230) bilden, und dass diese Öffnungen eine variable Geometrie haben.

4. Elektronische Vorrichtung nach einem der Ansprüche 1 bis 3, **dadurch gekennzeichnet, dass** die Zonen im Wesentlichen zylindrisch mit variablem Durchmesser in Abhängigkeit von der Position sind.

5. Elektronische Vorrichtung nach Anspruch 2, **dadurch gekennzeichnet, dass** die leitende Platte (23) von einer alternierenden Anordnung von Schichten (70, 71, 72) aus wärmeleitendem und wärmeisolierendem Werkstoff gebildet wird, um einen Wärmeverbund zu formen, der es ermöglicht, die Wärmezufuhr in Höhe jedes Kontaktplättchens zu steuern.

6. Elektronische Vorrichtung nach Anspruch 5, **dadurch gekennzeichnet, dass** die Platte eine erste gleichmäßige obere Schicht (70) aus wärmeleitendem Werkstoff und eine zweite untere Schicht (71) aus wärmeleitendem Werkstoff aufweist, die thermisch mit der ersten Schicht verbunden ist, wodurch eine Gruppe von Wärmeleitern (713) mit variablem Wärmewiderstand gebildet wird, die gemäß einem gegebenen Muster für die Steuerung der Wärmezufuhr in Höhe jedes Kontaktplättchens angeordnet sind.

7. Vorrichtung nach einem der Ansprüche 1 bis 6, **dadurch gekennzeichnet, dass** der wärmeleitende Werkstoff Kupfer ist.

8. Vorrichtung nach einem der Ansprüche 1 bis 6, **dadurch gekennzeichnet, dass** der wärmeleitende Werkstoff Kohlenstoff ist.

9. Elektronische Vorrichtung nach Anspruch 1, **dadurch gekennzeichnet, dass** die leitende Platte sich unter der Anschlussfläche befindet und ebenfalls elektrische Leitungseigenschaften hat, wobei die externen Anschlusskontaktplättchen in der Schicht ausgebildet sind.

10. Elektronische Vorrichtung nach einem der vorhergehenden Ansprüche, **dadurch gekennzeichnet, dass** die Vorrichtung vom Typ Gehäuse ist, das einen Träger (20) aufweist, der von mindestens einer Schicht aus elektrischem Isoliermaterial mit einer Oberseite (21) und einer Unterseite (22) gebildet wird, wobei die Unterseite die externe Anschlussfläche der Vorrichtung bildet, und außerdem eine Gruppe von elektronischen Bauteilen (50) aufweist, die in einer oder mehreren Ebenen angeordnet sind, wobei die Bauteile von elektrischen Leitern (51) an interne Anschlusskontaktplättchen (25) angeschlossen werden, die an der Oberseite des Trägers angeordnet sind, wobei die internen Anschlusskontaktplättchen mit den Kontaktplättchen der externen Anschlussfläche verbunden sind.

11. Elektronische Vorrichtung nach Anspruch 10,
**dadurch gekennzeichnet, dass**, wenn der Träger mehrschichtig ist und die leitende Platte sich über der Anschlussfläche befindet, die leitende Platte (23) eine oder mehrere der Schichten des Trägers bildet, wobei die Platte für den Durchgang der elektrischen Verbinder durchbohrt ist.

12. Elektronische Vorrichtung nach Anspruch 10,
**dadurch gekennzeichnet, dass** die elektronischen Bauteile auf dem Träger in mehreren Ebenen angeordnet sind, wobei die Bauteile der oberen Ebenen an die internen Anschlusskontaktplättchen über Anschlüsse (63) angeschlossen sind, die sich an den äußeren Seitenflächen des Gehäuses befinden.

13. Elektronische Vorrichtung nach Anspruch 12,
**dadurch gekennzeichnet, dass**, wenn die wärmeleitende Platte (23) mindestens eine Schicht aus leitendem Werkstoff aufweist, die Schicht geringere Abmessungen hat als diejenige des Trägers und eine gegebene Anzahl von Laschen (701) für den Wärmesteckanschluss an ihrem Umfang aufweist.

14. Elektronische Vorrichtung nach einem der vorhergehenden Ansprüche, **dadurch gekennzeichnet, dass** die externen Anschlusskontaktplättchen mit Kugeln (12) versehen sind.
